# EUROPÄISCHE PATENTANMELDUNG

(11) **EP 4 016 103 A1**
(43) Veröffentlichungstag der Anmeldung: **22.06.2022**
(21) Anmeldenummer: 20215748.3
(22) Anmeldetag: 18.12.2020
(51) Int. Cl.: G01R 33/36

(54) **MAGNETRESONANZTOMOGRAPH UND VERFAHREN ZUM SCHNELLEN UMSCHALTEN VON TX NACH RX**

(71) Anmelder: Siemens Healthcare GmbH, 91052 Erlangen (DE)
(72) Erfinder: Biber, Stephan, 91056 Erlangen (DE)

(57) **Zusammenfassung**

Die Erfindung betrifft einen Magnetresonanztomographen und ein Verfahren zum Betrieb eines Magnetresonanztomographen. In einem Schritt des Verfahrens werden in einem Sendezustand des Magnetresonanztomographen Kernspins in einem Untersuchungsobjekt mit einem Anregungspuls durch eine Hochfrequenzeinheit des Magnetresonanztomographen über eine Sendeantenne angeregt. In einem weiteren Schritt wird der Magnetresonanztomograph von in einem Zeitraum von weniger als 40 Mikrosekunden von dem Sendezustand in einen Empfangszustand umgeschaltet. In einem weiteren Schritt wird eine Magnetresonanzsignals in dem Empfangszustand mit einer Empfangsantenne empfangen.

## Beschreibung

Die Erfindung betrifft einen Magnetresonanztomographen und ein Verfahren zum Betrieb eines Magnetresonanztomographen. Der Magnetresonanztomograph weist eine Hochfrequenzeinheit, eine Sendeantenne und eine Empfangsantenne auf. Der Magnetresonanztomograph schaltet bei der Bildaufnahme von einem Sendezustand in einen Empfangszustand um.

Magnetresonanztomographen sind bildgebende Vorrichtungen, die zur Abbildung eines Untersuchungsobjektes Kernspins des Untersuchungsobjektes mit einem starken äußeren Magnetfeld ausrichten und durch ein magnetisches Wechselfeld zur Präzession um diese Ausrichtung anregen. Die Präzession bzw. Rückkehr der Spins aus diesem angeregten in einen Zustand mit geringerer Energie wiederum erzeugt als Antwort ein magnetisches Wechselfeld, das über Antennen empfangen wird.

Mit Hilfe von magnetischen Gradientenfeldern wird den Signalen eine Ortskodierung aufgeprägt, die nachfolgend eine Zuordnung von dem empfangenen Signal zu einem Volumenelement ermöglicht. Das empfangene Signal wird dann ausgewertet und eine dreidimensionale bildgebende Darstellung des Untersuchungsobjektes bereitgestellt. Zum Empfang des Signals werden vorzugsweise lokale Empfangsantennen, sogenannte Lokalspulen verwendet, die zur Erzielung eines besseren Signal-Rauschabstandes unmittelbar am Untersuchungsobjekt angeordnet werden.

Magnetresonanzsignale von Kernspins klingen exponentiell mit der Zeit ab, wobei die Abklingrate mit zunehmender Wechselwirkung der Kernspins mit der Umgebung steiler wird. Während im Wasser oder Fett die Kernspins noch nach Millisekunden Signale liefern, beträgt die Lebensdauer in Festkörpern wie Zähnen nur einen Bruchteil davon. Um noch Signale mit brauchbarem Signal-zu-Rauschabstand (SNR) zu erhalten, muss das Signal möglichst kurz nach dem Aussenden empfangen werden.

Der Anregungspuls wird üblicherweise über eine resonante Sendeantenne abgestrahlt, um möglichst hohe Feldstärken zu erzielen. Aufgrund der Resonanz klingt aber auch das Anregungssignal nach dem Abschalten des Senders exponentiell ab und stört einen frühzeitigen Empfang des Magnetresonanzsignals.

Es ist deshalb eine Aufgabe der Erfindung, die Bildaufnahme mit Magnetresonanzsignalen mit kurzen Relaxationszeiten zu verbessern.

Die Aufgabe wird durch einen Magnetresonanztomographen nach Anspruch 1 und ein Verfahren nach Anspruch 8 gelöst.

Das erfindungsgemäße Verfahren weist den Schritt auf, zu untersuchende Kernspins, beispielsweise Protonen, mit einem Anregungspuls durch die Hochfrequenzeinheit anzuregen. Der Anregungspuls wird in einem Sendezustand über eine Sendeantenne ausgesendet, vorzugsweise über eine Körperspule, denkbar ist aber auch eine Lokalspule mit Sendefunktion. Vorzugsweise hat der Anregungspuls eine Spitzenleistung von mehr als 50 W, 200 W oder 1000 W. Der Anregungspuls weist ein Frequenzspektrum auf, das um die Larmorfrequenz liegt, die durch das statische Magnetfeld B0 des Magnetresonanztomographen und die zu untersuchenden Kernspins definiert ist.

In einem weiteren Schritt empfängt der Magnetresonanztomograph über eine Empfangsantenne und die Hochfrequenzeinheit ein Magnetresonanzsignal für eine Bildgebung. Ein Signal ist insbesondere für die Bildgebung geeignet, wenn das Magnetresonanzsignal ein ausreichendes SNR zu einem Hintergrund- bzw. Störrauschen hat, beispielsweise ein SNR größer als 6 dB, 12 dB oder 18 dB. Die Empfangsantenne ist dabei vorzugsweise eine Lokalspule, kann aber auch eine Körperspule oder andere Antenne sein. Denkbar ist es dabei auch, dass die Sendeantenne auch die Empfangsantenne ist, also beispielsweise die Körperspule auch als Empfangsantenne genutzt wird oder die Lokalspule sowohl eine Sende- und Empfangsfunktionalität hat.

Als Sendezustand wird dabei ein Zustand bzw. Einstellung von Hochfrequenzeinheit, Sendeantenne und/oder Empfangsantenne bezeichnet, der ein Aussenden des Anregungspulses mit der gewünschten Anregung der Kernspins als Ergebnis erlaubt und gleichzeitig eine Beschädigung des Magnetresonanztomographen, insbesondere der Sendeantenne, Empfangsantenne und/oder Hochfrequenzeinheit verhindert.

Als Empfangszustand wird dabei ein Zustand von Hochfrequenzeinheit, Sende und Empfangsantenne bezeichnet, der es erlaubt, ein Magnetresonanzsignal der zu untersuchenden Kernspins mit der Empfangsantenne und der Hochfrequenzeinheit aufzunehmen, das eine Bildrekonstruktion ermöglicht. Insbesondere sind aufgenommene Signale mit einem zu geringen SNR und/oder zu hohem Störpegel nicht geeignet. Das SNR bzw. der Störabstand ist vorzugsweise größer als 6 dB, 12 dB oder 18 dB.

In dem erfindungsgemäßen Verfahren erfolgt ein Umschalten von dem Sendezustand in den Empfangszustand in weniger als 40 Microsekunden. Wie dieses schnelle Umschalten in den einzelnen Ausführungsformen erreicht wird, ist in den nachfolgenden Unteransprüchen näher dargelegt.

Auf vorteilhafte Weise ermöglicht das schnelle Umschalten von Sendezustand in den Empfangszustand, ein Magnetresonanzsignal zu einem möglichst frühen Zeitpunkt zu erfassen, bevor die Amplitude zu weit für einen ausreichenden Signal-zu-RauschAbstand abgefallen ist. Dadurch wird eine Bilderfassung auch in Festkörpern mit starker Wechselwirkung und kurzer Zeitkonstante T1 für den Zerfall des angeregten Kernspinzustands verbessert.

Der erfindungsgemäße Magnetresonanztomograph teilt die Vorteile des erfindungsgemäßen Verfahrens.

Weitere vorteilhafte Ausführungsformen sind in den Unteransprüchen angegeben.

In einer möglichen Ausführungsform des erfindungsgemäßen Magnetresonanztomographen weist die Hochfrequenzeinheit eine oder mehrere Verstimmeinrichtungen auf und/oder eine Sende-Empfangsweiche, mit anderen Worten zwei Verstimmeinrichtungen oder mindestens eine Verstimmeinrichtung und eine Sende-Empfangsweiche. Mit Verstimmeinrichtung wird eine Vorrichtung bezeichnet, mit der die Resonanzfrequenz oder die Güte einer Antenne durch ein Steuersignal verändert werden kann. Üblicherweise werden PIN-Dioden als Kurzschlussschalter oder Unterbrecher eingesetzt. Eine Sende-Empfangsweiche bezeichnet eine Vorrichtung, mit der der Weg eines Hochfrequenzsignals, beispielsweise eines Magnetresonanzsignals von der Empfangsantenne zum Empfänger und/oder eines Anregungspulses von einem Hochfrequenz-Leistungsverstärker zu einer Sendeantenne verändert werden kann. Der Magnetresonanztomograph weist weiterhin eine Ansteuerung auf, die in Signalverbindung mit mindestens zwei Verstimmeinrichtungen oder mindestens einer Verstimmeinrichtung und der Sende-Empfangsweiche steht. Die Ansteuerung ist dabei ausgelegt, für diese Einheiten ein Umschalten von einem Sendezustand in einen Empfangszustand gleichzeitig einzuleiten.

Beispielsweise können beide umzuschaltende Einheiten mit einer gemeinsamen Signalleitung verbunden sein.

Als gleichzeitig wird insbesondere im Sinne der Erfindung auch verstanden, dass ein Schaltvorgang begonnen wird, bevor ein anderer Schaltvorgang des Umschaltens beendet ist. Beispielsweise kann der Eingang des Hochfrequenz-Leistungsverstärker stumm geschaltet werden, sobald der Anregungspuls beendet ist, z.B. 0 bis 10 Mikrosekunden danach. Innerhalb eines Zeitfensters von 5 bis 10 Mikrosekunden um diesen Zeitpunkt herum werden anschließend die Sende-Verstimmeinrichtung in den verstimmten Zustand, die Empfangs-Verstimmeinrichtung in den abgestimmten Zustand und/oder die Sende-Empfangsweiche Empfangszustand gebracht.

Üblicherweise erfolgt zunächst ein Deaktivieren der Sendeantenne bevor die Empfangsantenne aktiviert wird, um eine Störung bzw. Zerstörung der Empfangsantenne durch die nachschwingende Sendeanatenne zu verhindern. Bei geeigneter Auslegung der Sende-Empfangswege ist es aber auf vorteilhafte Weise möglich, durch ein gleichzeitiges Beenden des Sendezustandes und Aktivieren des Empfangszustandes den Abstand zwischen Anregung und Empfang des Magnetresonanzsignals so verkürzen, dass auch Kernspins mit kurzer Relaxationszeit abgebildet werden können. Auch ist es dadurch möglich, ein durch das Schalten des Sende-Empfangsweiche verursachtes Störsignal durch eine bereits aktivierte Verstimmeinrichtung zu dämpfen.

In einer denkbaren Ausführungsform des erfindungsgemäßen Magnetresonanztomographen weist die Ansteuerung eine Synchronisierungseinrichtung auf. Die Synchronisierungseinrichtung ist ausgelegt, einen Jitter beim gleichzeitigen Umschalten auf einen Wert kleiner 5 Microsekunden, 2 Microsekunden oder 1 Mikrosekunde zu begrenzen. Beispielsweise ist es denkbar, dass die Signalverbindungen von der Ansteuerung zu den Verstimmeinrichtungen und/oder Sende-Empfangsweiche über ein getaktetes Gatter laufen, die am Eingang von der Ansteuerung angelegte Signale gleichzeitig von einem Taktsignal an den Ausgang des Gatters zu den Verstimmeinrichtungen und/oder der Sende-Empfangsweiche weitergeschaltet werden.

Auf vorteilhafte Weise reduziert die Synchronisierungseinrichtung die zeitliche Abweichung der einzelnen Umschaltvorgänge und erlaubt so insgesamt den Umschaltvorgang zu beschleunigen.

In einer möglichen Ausführungsform des erfindungsgemäßen Magnetresonanztomographen weist der Magnetresonanztomograph eine Pickup-Spule zum Aufnehmen des Abklingens der Sendeantenne nach einem Aussenden eines Anregungspulses auf.

Auf vorteilhafte Weise erlaubt es die Pickup-Spule, eine Aussendung einer Sendeantenne, beispielsweise einer Körperspule, zu verfolgen und zu erkennen, wenn die Amplitude des von der abklingenden Anregung erzeugten hochfrequenten Wechselfeldes unter einen vorbestimmten Wert fällt, bei dem das abklingende Wechselfeld noch einen Empfang des Magnetresonanzsignals verhindert. Als Pickup-Spule wird insbesondere ein von der Empfangsantenne unabhängiger Sensor bezeichnet. Beispielsweise kann so bei einem Patienten mit großer Körpermasse durch die erhöhte Dämpfung ein früheres Umschalten in den Empfangszustand ermöglicht werden.

In einer anderen denkbaren Ausführungsform des erfindungsgemäßen Magnetresonanztomographen ist die Hochfrequenzeinheit ausgelegt, in dem Sendezustand mit der Empfangsantenne eine Aussendung der der Sendeantenne aufzunehmen. Beispielsweise ist es denkbar, dass in dem Sendezustand die Empfangsantenne derart verstimmt ist, dass das empfangene Anregungssignal den Empfänger für Magnetresonanzsignale der Hochfrequenzeinheit nicht übersteuert oder zerstört, aber dennoch ausgewertet werden kann. Denkbar ist auch ein im Sendezustand in die Signalverbindung zwischen der Empfangsspule und dem Empfänger geschaltetes Dämpfungsglied.

Auch in dieser Ausführungsform kann so bei einem Patienten mit großer Körpermasse durch die erhöhte Dämpfung ein früheres Umschalten in den Empfangszustand ermöglicht werden.

In einer möglichen Ausführungsform des erfindungsgemäßen Magnetresonanztomographen weist die Sende-Empfangsweiche zwei Schalter auf. Als Schalter werden hierbei alle Bauelemente angesehen, die gesteuert über einen Steuereingang eine elektrische Verbindung, insbesondere für ein Hochfrequenzsignal, unterbrechen oder herstellen können. Beispiele sind mechanische Schaltrelais, MEMS, Transistoren oder FET oder auch Schaltdioden wie PIN-Dioden. Die Schalter bewirken gemeinsam ein Umschalten zwischen einem Sendezustand und einem Empfangszustand der Sende-Empfangsweiche. Denkbar wären beispielsweise eine Parallelschaltung und/oder Serienschaltung der beiden Schalter. Die beiden Schalter weisen zwei unterschiedliche Treiberkreise auf. Mit anderen Worten, die beiden Schalter können unabhängig voneinander geschaltet werden, insbesondere auch zu unterschiedlichen Zeitpunkten. Dies kann von der Steuerung 23 koordiniert werden. Denkbar ist aber auch, dass der erste der Treiberkreisen eine längere Zeitkonstante als der zweite Treiberkreis aufweist. In diesem Fall können die beiden Treiberkreise gleichzeitig von der Steuerung 23 angesteuert werden, aber die unterschiedliche Zeitkonstante sorgt dann dafür, dass die beiden Schalter in einer vorbestimmten Weise nacheinander betätigt werden.

Auf vorteilhafte Weise wird durch das sukzessive Schalten der beiden Schalter eine Amplitude der durch den Schaltvorgang verursachten Störungen reduziert.

In einer denkbaren Ausführungsform des erfindungsgemäßen Magnetresonanztomographen weist die Hochfrequenzeinheit einen Hochfrequenz-Leistungsverstärker mit einem Steuersignaleingang zum Unterdrücken einer Aussendung auf. Mit anderen Worten, der Hochfrequenz-Leistungsverstärker wird durch ein Signal auf dem Steuersignaleingang stummgeschaltet, aber nicht von der Sendeantenne getrennt. Beispielsweise kann der Eingang des Hochfrequenz-Leistungsverstärker auf einen Abschluss geschaltet werden, der ein minimales Rauschsignal einspeist. Denkbar ist auch eine Gleichspannung, bei der ein Rauschmaß des Verstärkers minimal ist.

Häufig wird der Hochfrequenz-Leistungsverstärker im Empfangszustand völlig von der Sendeantenne getrennt, um eine Rauschaussendung zu minimieren. Der erfindungsgemäße Steuersignaleingang ermöglicht hingegen ein schnelleres Umschalten in den Empfangszustand, unter anderem auch, weil durch den verbundenen Hochfrequenz-Leistungsverstärker die Sendeantenne stärker bedämpft wird.

In einer denkbaren Ausführungsform des erfindungsgemäßen Verfahrens erfasst die Hochfrequenzeinheit beim Umschalten von einem Sendezustand in einen Empfangszustand ein von der Sendeantenne ausgesendetes hochfrequentes magnetisches Wechselfeld. Die Sendeantenne schwingt beispielsweise durch ihre Resonanz auf der Frequenz des Anregungspulses nach, auch können durch die Umschaltvorgänge zusätzliche Hochfrequenzsignale erzeugt und über die Sendeantenne emittiert werden. Das Abklingen der Signale hängt unter anderem auch von einer Dämpfung durch den Patienten ab. Das Erfassen des hochfrequenten magnetischen Wechselfeldes kann beispielsweise mit der bereits erwähnten Pickup-Spule erfolgen. Denkbar ist auch das Erfassen mittels einer Lokalspule, wenn deren Eingang im Sendezustand ausreichend bedämpft ist. Die Hochfrequenzeinheit schaltet erst dann in den Empfangszustand, wenn eine Stärke des elektromagnetischen Wechselfeldes einen vorbestimmten Grenzwert unterschreitet, beispielsweise eine Amplitude, die einen Empfänger der Hochfrequenzeinheit für das Magnetresonanzsignal im Empfangszustand nicht mehr übersteuert.

Auf vorteilhafte Weise kann durch das Erfassen der Emission der Sendespule während des Umschaltens von Sendezustand in den Empfangszustand der Empfang zu einem frühestmöglichen Zeitpunkt aufgenommen werden, bei dem das Magnetresonanzsignal noch eine größere Amplitude aufweist.

In einer möglichen Ausführungsform des erfindungsgemäßen Verfahrens weist die Hochfrequenzeinheit eine Sende-Empfangsweiche zwischen einem Hochfrequenz-Leistungsverstärker und der Sendeantenne auf. Die Sendeantenne verbleibt in dieser Ausführungsform des Verfahrens im Empfangszustand in elektrischer Signalverbindung mit der Sendeantenne.

Üblicherweise ist die Sende-Empfangsweiche vorgesehen, um in einem Empfangszustand bei Magnetresonanzaufnahmen mit langsamer Relaxationszeit der Kernspins den Hochfrequenz-Leistungsverstärker von der Sendeantenne elektrisch zu trennen, um eine Rauschemission des Hochfrequenz-Leistungsverstärkers als auch Dämpfung des Magnetresonanzsignals zu minimieren. Allerdings verursacht der Umschaltprozess selbst wieder Störungen und benötigt Zeit, bis diese abklingen. In dieser Ausführungsform des erfindungsgemäßen Verfahrens hingegen ermöglicht es der Verzicht auf ein Umschalten der Sende-Empfangsweiche auf vorteilhafte Weise, schneller in den Empfangszustand zu gehen und damit ein Magnetresonanzsignal der schnell relaxierenden Kernspins mit höherer Amplitude aufzunehmen.

In einer anderen denkbaren Ausführungsform des erfindungsgemäßen Verfahrens weist die Hochfrequenzeinheit eine Sende-Empfangsweiche zwischen einem Hochfrequenz-Leistungsverstärker und der Sendeantenne mit zwei Schaltern auf. Die Hochfrequenzeinheit schaltet dabei beim Umschalten vom Sendezustand in den Empfangszustand die beiden Schalter nacheinander. Beispielsweise kann die Hochfrequenzeinheit die Schalter in zeitlichem Abstand nacheinander betätigt. Es ist aber auch denkbar, dass die Treiberschaltung der Schalter eine unterschiedliche Verzögerung aufweisen, sodass die Hochfrequenzeinheit beide Treiber gleichzeitig ansteuert, aber die Schalter nacheinander schalten.

Auf vorteilhafte Weise ermöglicht die Aufteilung auf zwei Schalter mit einem versetzten Schaltzeitpunkt ein Reduzieren der durch den Schaltvorgang erzeugten Störungen.

In einer möglichen Ausführungsform des erfindungsgemäßen Verfahrens ist die Sendespule eine Körperspule. Die Hochfrequenzeinheit belässt dabei die Körperspule im Empfangszustand im abgestimmten Zustand, mit anderen Worten aktiviert kein Verstimmen.

Das Verstimmen der Körperspule verursacht Schwankungen in Magnetresonanzsignalen, die von der Lokalspule als Empfangsantenne aufgenommen werden. Indem auf das Verstimmen der Körperspule verzichtet wird, können auf vorteilhafte Weise Magnetresonanzsignale zu einem früheren Zeitpunkt ungestört aufgenommen werden.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Es zeigen:
- Fig. 1: eine schematische Darstellung eines erfindungsgemäßen Magnetresonanztomographen;
- Fig. 2: eine schematische Darstellung der an dem Verfahren beteiligten Vorrichtungen des Magnetresonanztomographen;
- Fig. 3: ein beispielhaftes schematisches Ablaufdiagramm einer Ausführungsform des erfindungsgemäßen Verfahrens.

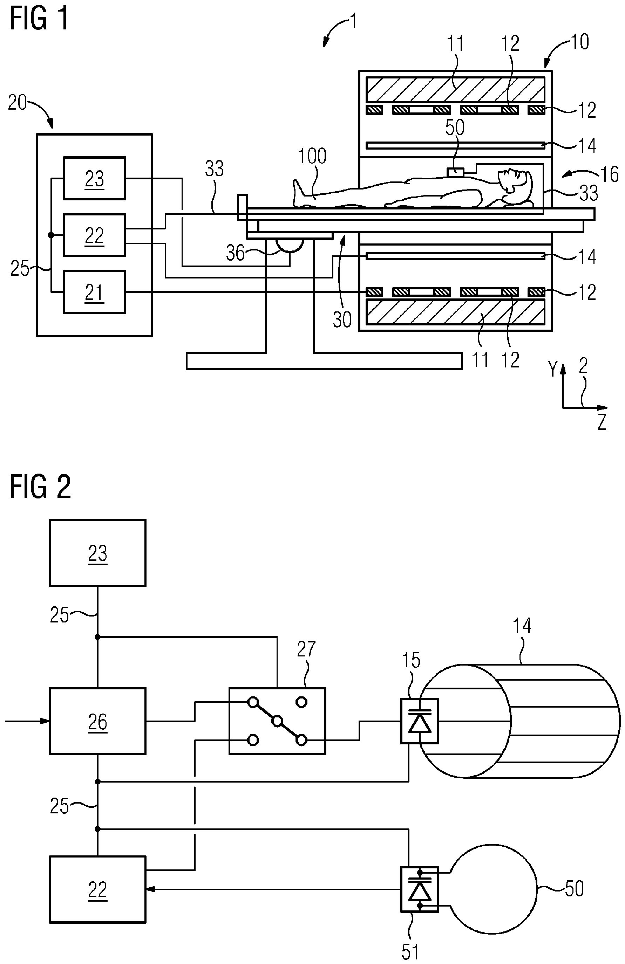

Fig. 1 zeigt eine schematische Darstellung einer beispielhafte Ausführungsform eines erfindungsgemäßes Magnetresonanztomographen.

Die Magneteinheit 10 weist einen Feldmagneten 11 auf, der ein statisches Magnetfeld B0 zur Ausrichtung von Kernspins von Proben bzw. des Patienten 100 in einem Aufnahmebereich erzeugt. Der Aufnahmebereich zeichnet sich durch ein äußerst homogenes statisches Magnetfeld B0 aus, wobei die Homogenität insbesondere die Magnetfeldstärke bzw. den Betrag betrifft. Der Aufnahmebereich ist nahezu kugelförmig und in einem Patiententunnel 16 angeordnet, der sich in einer Längsrichtung 2 durch die Magneteinheit 10 erstreckt. Eine Patientenliege 30 ist in dem Patiententunnel 16 von der Verfahreinheit 36 bewegbar.

Üblicherweise handelt es sich bei dem Feldmagneten 11 um einen supraleitenden Magneten, der magnetische Felder mit einer magnetischen Flussdichte von bis zu 3T, bei neuesten Geräten sogar darüber, bereitstellen kann. Für geringere Feldstärken können jedoch auch Permanentmagnete oder Elektromagnete mit normalleitenden Spulen Verwendung finden.

Weiterhin weist die Magneteinheit 10 Gradientenspulen 12 auf, die dazu ausgelegt sind, zur räumlichen Differenzierung der erfassten Abbildungsbereiche in dem Untersuchungsvolumen dem Magnetfeld B0 variable Magnetfelder in drei Raumrichtungen zu überlagern. Die Gradientenspulen 12 sind üblicherweise Spulen aus normalleitenden Drähten, die zueinander orthogonale Felder in dem Untersuchungsvolumen erzeugen können.

Die Magneteinheit 10 weist ebenfalls eine Körperspule 14 auf, die dazu ausgelegt ist, ein über eine Signalleitung zugeführtes Hochfrequenzsignal in das Untersuchungsvolumen abzustrahlen und von dem Patient 100 emittierte Resonanzsignale zu empfangen und über eine Signalleitung abzugeben. Im Folgenden bezeichnet der Begriff Sendeantenne eine Antenne, über die das Hochfrequenzsignal zur Anregung der Kernspins ausgestrahlt wird. Dies kann die Körperspule 14 sein, aber auch eine Lokalspule 50 mit Sendefunktion.

Eine Steuereinheit 20 versorgt die Magneteinheit 10 mit den verschiedenen Signalen für die Gradientenspulen 12 und die Körperspule 14 und wertet die empfangenen Signale aus.

So weist die Steuereinheit 20 eine Gradientenansteuerung 21 auf, die dazu ausgelegt ist, die Gradientenspulen 12 über Zuleitungen mit variablen Strömen zu versorgen, welche zeitlich koordiniert die erwünschten Gradientenfelder in dem Untersuchungsvolumen bereitstellen.

Weiterhin weist die Steuereinheit 20 eine Hochfrequenzeinheit 22 auf, die ausgelegt ist, einen Hochfrequenz-Puls mit einem vorgegebenen zeitlichen Verlauf, Amplitude und spektraler Leistungsverteilung zur Anregung einer Magnetresonanz der Kernspins in dem Patienten 100 zu erzeugen. Dabei können Pulsleistungen im Bereich von Kilowatt erreicht werden. Die Anregungssignale können über die Körperspule 14 oder auch über eine lokale Sendeantenne in den Patienten 100 abgestrahlt werden. Die Körperspule 14 weist als Verstimmeinrichtung eine Sende-Verstimmeinrichtung 15 auf, mit der die Körperspule 14 zwischen einer Sendeabstimmung und einer Empfangsabstimmung geschaltet werden kann. Vorzugsweise ist die Körperspule 14 beim Senden auf die Larmorfrequenz abgestimmt, während im Empfangszustand zum Empfang über die nachfolgend ausgeführten Lokalspulen 50 die Körperspule 14 von der Sende-Verstimmeinrichtung 15 so verstimmt ist, dass sie nicht auf der Larmorfrequenz resoniert, um nicht an die Magnetresonanzsignale zu koppeln. Über eine Sende-Empfangsweiche 27 wird im Sendezustand ein Hochfrequenz-Leistungsverstärker 26 mit der Körperspule 14 oder einer anderen Sendeantenne verbunden. Die Sende-Empfangsweiche 27 kann diese Verbindung gesteuert von einer Steuerung 23 unterbrechen oder die Sendeantenne bzw. Körperspule 14 mit einem Abschlusswiderstand verbinden.

Die Steuerung 23 kommuniziert über einen Signalbus 25 mit der Gradientensteuerung 21 und der Hochfrequenzeinheit 22.

Auf dem Patienten 100 ist als Empfangsantenne eine Lokalspule 50 angeordnet, die über eine Anschlussleitung 33 mit der Hochfrequenzeinheit 22 und deren Empfänger verbunden ist. Denkbar ist es aber auch, dass die Körperspule 14 eine Empfangsantenne ist.

Die Lokalspule 15 weist als Verstimmeinrichtung eine Empfangs-Verstimmeinrichtung 51 auf, mit der die Lokalspule 50 zwischen einer Sendeabstimmung und einer Empfangsabstimmung geschaltet werden kann. Vorzugsweise ist die Lokalspule 50 beim Senden über die Körperspule 14 so verstimmt, dass sie nicht auf der Larmorfrequenz resoniert, um nicht durch die hohe Leistung des Anregungspulses zerstört zu werden. Während des Empfangs ist die Lokalspule 50 durch die Empfangs-Verstimmeinrichtung 51 auf die Larmorfrequenz abgestimmt.

Fig. 2 zeigt beispielhaft eine schematische Darstellung von an dem Verfahren beteiligten Vorrichtungen des Magnetresonanztomographen.

Eine Körperspule 14 als Sendeantenne weist eine Sende-Verstimmeinrichtung 15 auf. Diese ist symbolisch durch eine PIN-Diode als Schaltelement dargestellt, weitere Elemente wie Kondensatoren zur Gleichspannungsentkopplung oder Induktivitäten als Hochfrequenzsperre sind nicht dargestellt. Die PIN-Diode kann durch eine Gleichspannung in Vorwärtsrichtung durchgeschaltet werden oder durch eine Sperrspannung als einstellbare Kapazität verwendet werden. Je nach Schaltung kann beispielsweise die Empfangsantenne von der PIN-Diode kurzgeschlossen oder die Sendeantenne durch eine über die PIN-Diode zugeschaltete Kapazität verstimmt werden.

Die Verstimmeinrichtungen können über eine Signalverbindung von der Steuerung 23 mittels einer Spannung oder Stroms geschaltet werden. Denkbar ist auch eine Steuerschaltung in der Verstimmeinrichtung, die durch ein Kommando über die Signalverbindung die PIN-Diode mit einer Spannung oder einem Strom beaufschlagt.

Auch die Lokalspule 50 als Empfangsantenne weist eine entsprechende Empfangs-Verstimmeinrichtung 51 auf, die ebenfalls mit einer PIN-Diode realisiert sein kann. Die Ausführungen zur Schaltungstechnik der Sende-Verstimmeinrichtung 15 gelten sinngemäß auch für die Empfangs-Verstimmeinrichtung 51. Vorzugsweise verstimmt die Empfangs-Verstimmeinrichtung 51 die Lokalspule 50 im Sendezustand, um sie vor Beschädigung durch den Anregungspuls zu schützen und macht sie im Empfangszustand resonant auf der Larmorfrequenz der zu untersuchenden Kernspins, sodass die Empfindlichkeit für das zu empfangende Magnetresonanzsignal möglichst groß ist.

Die Körperspule 14 ist als Sendeantenne über eine Signalverbindung mit dem Hochfrequenz-Leistungsverstärker 26 verbunden, von dem sie mit einem Hochfrequenzsignal wie einem Anregungspuls versorgt werden kann. In die Signalverbindung ist eine Sende-Empfangsweiche 27 geschaltet, die von der Steuerung 23 angesteuert, die Sendeantenne in einem Sendezustand mit dem Hochfrequenz-Leistungsverstärker 26 verbindet.

In einem Empfangszustand sind unterschiedliche Verbindungen denkbar. Beispielsweise kann die Verbindung zwischen Sendeantenne und Hochfrequenz-Leistungsverstärker von der Sende-Empfangsweiche 27 unterbrochen werden. Denkbar ist, wenn die Körperspule 14 auch Empfangsantenne ist, dass die Sende-Empfangsweiche 27 eine Signalverbindung zwischen der Körperspule 14 und einem Empfänger in der Hochfrequenzeinheit 22 herstellt. Denkbar ist auch, dass im Empfangszustand die Sendeantenne und/oder der Hochfrequenz-Leistungsverstärker 26 mit einer Signalsenke wie einem Abschlusswiderstand verbunden wird. Die Sende-Empfangsweiche 27 weist für diesen Zweck zumindest einen Schalter auf, der die Verbindung zwischen hochfrequenz-Leistungsverstärker 26 und der Sendeantennen gesteuert von der Steuerung 23 unterbrechen kann. Denkbar ist auch ein Mehrwegschalter, der beispielsweise auch die Körperspule 14 mit einem Empfänger der Hochfrequenzeinheit verbinden kann oder den Hochfrequenz-Leistungsverstärker 26 mit einer Signalsenke wie einem Dummy. Denkbar ist es auch, dass die Sende-Empfangsweiche ein passives Bauelement wie einen Gyrator aufweist, der ein Signal abhängig von der Ausbreitungsrichtung weiterleitet.

Denkbar ist auch ein Umschalten durch mehrere Schalter in Serie, parallel oder auch in komplexeren Anordnungen, durch die der Schaltvorgang auf mehrere Schalter verteilt wird. Indem die Betätigung der Schalter zu unterschiedlichen Zeitpunkten erfolgt, kann ein durch den Schaltvorhang entstehendes Störsignal in der Amplitude, z.B. durch die geringeren Ströme oder Ladungen, reduziert werden und der gesamte Schaltvorgang beschleunigt werden.

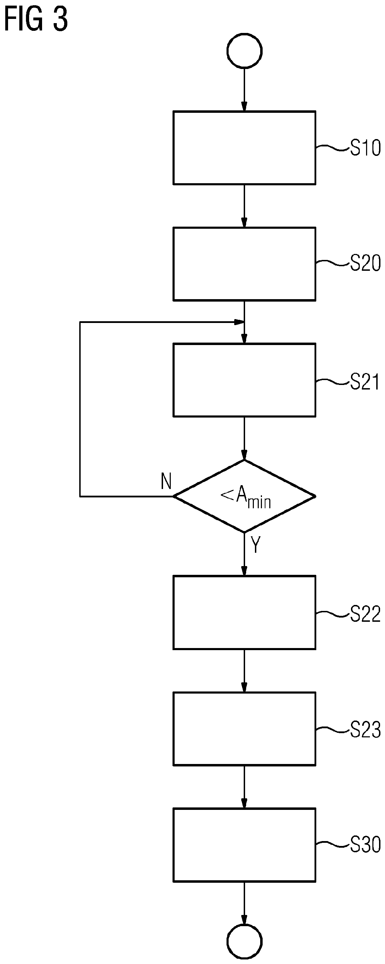

Fig. 3 zeigt einen beispielhaften Ablaufplan eines erfindungsgemäßen Verfahrens.

In einem Schritt S10 regt der Magnetresonanztomograph mit einem Anregungspuls aus dem Hochfrequenz-Leistungsverstärker 26 über die Sendeantenne, beispielsweise die Körperspule 14, zu erfassende Kernspins in dem Patienten 100 an. Dabei befindet sich der Magnetresonanztomograph 1 in einem Sendezustand, in dem die Sende-Verstimmeinrichtung 15 die Sendeantenne auf die Larmorfrequenz abstimmt, um vorzugsweise mit dem erzeugten B1-Feld eine möglichst starke und homogene Anregung zu erzeugen. Insbesondere stellt im Sendezustand die Sende-Empfangsweiche 27 eine elektrische Verbindung zwischen dem Hochfrequenz-Leistungsverstärker 26 und der Sendeantenne für den Anregungspuls her, wobei der Anregungspuls vorzugsweise nur in geringem Umfang, z.B. kleiner als 6 dB, 3 dB oder 1 dB zwischen dem Hochfrequenz-Leistungsverstärker und der Sendeantenne gedämpft wird.

Die Empfangsspule, beispielsweise eine Lokalspule 50, ist im Sendezustand vorzugsweise durch die Empfangs-Verstimmeinrichtung 51 in einen Zustand versetzt, in dem der Anregungspuls keinen Schaden an der Empfangsantenne hervorrufen kann oder eine Gefahr für den Patienten 100 durch Erwärmung oder induzierte Spannungen darstellt. Die Empfangs-Verstimmeinrichtung 51 verstimmt dabei vorzugsweise Empfangsantenne in ihrer Resonanzfrequenz derart, dass die durch den Anregungspuls induzierte Spannung um mehr als 24 dB, 48dB, 60 dB oder 96 dB gegenüber dem abgestimmten Zustand reduziert wird. Alternativ oder vorzugsweise ergänzend ist auch denkbar, dass die Verstimmeinrichtung die Empfangsantenne oder Segmente davon beispielsweise mit einer PIN-Diode kurzschließt.

In einem Schritt S20 führt die Steuerung 23 ein Umschalten von dem Sendezustand in den Empfangszustand mittels der Sende-Verstimmeinrichtung 14 und der Empfangs-Verstimmeinrichtung 51 sowie der Sende-Empfangsweiche 27 durch. Das Umschalten erfolgt erfindungsgemäß in weniger als 40 Mikrosekunden, um einen Empfang des exponentiell abfallenden Magnetresonanzsignals zu einem möglichst frühen Zeitpunkt und damit mit einer möglichst großen Amplitude zu ermöglichen. Da erfindungsgemäß unterschiedliche Mechanismen dies ermöglichen und diese wiederum von den Details des Endzustands, d.h. dem Empfangszustand abhängen, sei im Folgenden zunächst auf diesen eingegangen, bevor der Umschaltvorgang in Schritt S20 genauer ausgeführt wird.

In einem Schritt S30 empfängt der Magnetresonanztomograph 1 ein Magnetresonanzsignal mit einem Empfänger der Hochfrequenzeinheit 22 über eine Empfangsantenne, beispielsweise die Lokalspule 50. Das Magnetresonanzsignal wird von der Hochfrequenzeinheit 22 aufbereitet und anschließend von einem Rechner, beispielsweise der Steuereinheit 20 oder einem externen Rechner, eine Abbildung rekonstruiert und gespeichert oder ausgegeben. Dabei befinden sich die Sende-Verstimmeinrichtung 15, die Empfangs-Verstimmeinrichtung 51 und die Sende-Empfangsweiche in einem Empfangszustand.

Der Empfangszustand ist für die Empfangsantenne durch eine Einstellung der Empfangs-Verstimmeinrichtung 51 definiert, bei der die Empfangsantenne auf der Larmorfrequenz des Magnetresonanzsignales ein im Wesentlichen maximales Signal liefert und/oder ein Signal mit einem im Wesentlichen maximalen Signal-zu-Rauschabstand. Als im Wesentlichen maximal wird verstanden, wenn die Amplitude des Signals um weniger als 3 dB, 6 dB oder 12 dB unter einem absoluten Maximum für das gegebenen Magnetresonanzsignal liegt. Üblicherweise ist dies der Fall, wenn die Empfangsantenne resonant auf der Larmorfrequenz ist, beispielsweise indem eine Antennenschleife einer Lokalspule 50 durch einen Serienkondensator der Empfangs-Verstimmeinrichtung 51 resonant abgestimmt wird. Es ist aber auch denkbar, dass durch eine stärkere Kopplung der Antennenschleife mit einem Eingangsverstärker die Resonanz breiter, aber mit kleinerer Amplitude eingestellt wird, sodass zwar das maximale Signal kleiner ist, aber auch bei Resonanzverschiebung durch den Patienten 100 noch ein hohes Signal liefert. Es ist auch denkbar, dass der Empfangszustand ein Einstellen einer Anpassungsschaltung der Empfangs-Verstimmeinrichtung 51 umfasst, um ein Rauschmaß der Eingangsstufe minimiert.

Die Sendeantenne, sofern diese nicht gleichzeitig die Empfangsantenne ist, wird in einer denkbaren Ausführungsform des erfindungsgemäßen Verfahrens im Empfangszustand verstimmt, d.h. von der Sende-Verstimmeinrichtung 15 auf eine Resonanzfrequenz abgestimmt, die so weit von der Larmorfrequenz entfernt ist, dass ein Signal, das durch ein B1-Feld der Kernspins in der Sendeantenne induziert wird, um mehr als 12 dB, 24 dB, 48 dB oder 60 dB gegenüber einem Signal der Sendeantenne mit einer Resonanzfrequenz gleich der Larmorfrequenz und gleichem B1 gedämpft wird.

Es ist aber auch denkbar, dass alternativ oder ergänzend die Sende-Verstimmeinrichtung 15 die Sendeantenne bedämpft, beispielsweise indem die Sende-Verstimmeinrichtung 15 einen Widerstand wesentlich kleiner als die Impedanz der Sendeantenne über deren Speisepunkt schließt oder diesen kurzschließt. Denkbar ist es auch, dass die Sende-Verstimmeinrichtung 15 die Sendeantenne an zwei Orten ungleich dem Speisepunkt kurzschließt, sodass die Sendeantenne in zwei im Wesentlichen gleich große Segmente unterteilt wird, was gleichzeitig die Resonanzfrequenz wesentlich verändert.

Die Sende-Empfangsweiche 27 kann je nach Ausführungsform des erfindungsgemäßen Verfahrens im Empfangszustand den Hochfrequenz-Leistungsverstärker 26 von der Sendeantenne trennen oder auch eine elektrische Verbindung aufrechterhalten.

Wenn die Sende-Empfangsweiche 27 die Verbindung trennt, kann auf der einen Seite zwar ein Leerlauf-Rauschen des Hochfrequenz-Leistungsverstärkers 26 nicht mehr über die Sendeantenne ausgesendet werden. Die Sendeantenne wird dann aber auch nicht mehr von dem Hochfrequenz-Leistungsverstärker 26 bedämpft, sodass diese länger auf der Frequenz und mit der Energie des Anregungspulses nachschwingt.

Trennt in einer Ausführungsform des erfindungsgemäßen Verfahrens die Sende-Empfangsweiche 27 den Hochfrequenz-Leistungsverstärker 26 nicht von der Sendeantenne, so weist der Hochfrequenz-Leistungsverstärker vorzugsweise einen Steuereingang auf, über den er stumm geschaltet werden kann. Die Steuerung 23 schaltet dann den Hochfrequenz-Leistungsverstärker 26 stumm bzw. erdet den Signaleingang, sodass das Rauschen auf das Eigenrauschen der Endstufe minimiert wird, gleichzeitig aber die Sendeantenne über die Verbindung zu dem Hochfrequenz-Leistungsverstärker 26 mit einer passenden Impedanz abgeschlossen und durch den Ausgangswiderstand der Endstufe bedämpft ist.

Das Umschalten in Schritt S20 kann sich je nach dem Empfangszustand der jeweiligen Ausführungsform des Verfahrens unterscheiden.

Bleibt beispielsweise die Signalverbindung zwischen dem Hochfrequenz-Leistungsverstärker 26 und der Sendeantenne im Empfangszustand bestehen, so wird im Schritt des Umschaltens von der Steuerung 23 über einen Steuersignaleingang des Hochfrequenz-Leistungsverstärkers dieser stumm geschaltet. So kann der Hochfrequenz-Leistungsverstärker 26 die Sendeantenne bedämpfen und sorgt so für ein schnelleres Abklingen des Anregungspulses in der Sendeantenne, sodass schneller der Empfangszustand erreicht wird. Gleichzeitig wird das Rauschen des Hochfrequenz-Leistungsverstärkers 26 durch die Stummschaltung reduziert. Der Gewinn an Signalstärke des empfangenen Signals durch den früheren Umschaltzeitpunkt überwiegt dabei das höhere Rauschen, sodass insgesamt das SNR verbessert wird.

In einer anderen Ausführungsform des erfindungsgemäßen Verfahrens trennt während des Umschaltens die Sende-Empfangsweiche 27 den Hochfrequenz-Leistungsverstärker 26 von der Sendeantenne. Dabei weist die Sende-Empfangsweiche 27 zwei Schalter auf, die die Verbindung gemeinsam herstellen, wenn sie geschlossen sind, bzw. trennen, wenn beide geöffnet sind. Die Steuerung 23 öffnet dabei in einem Schritt S23 die Schalter nacheinander, beispielsweise in einem Abstand von mehr als 5 Mikrosekunden, 10 Mikrosekunden oder 20 Mikrosekunden, aber in einem Abstand von weniger als 30 Mikrosekunden. Das Trennen der Verbindung selbst erzeugt Störungen, die durch die Verteilung über zwei Schalter, beispielsweise parallel oder seriell geschaltet, die zu unterschiedlichen Zeiträumen betätigt werden, reduziert werden. Dadurch klingen diese schneller ab und es kann trotz der zusätzlichen Verzögerung früher der Empfangszustand erreicht werden, in dem ein Magnetresonanzsignal aufgenommen wird.

In einer bevorzugten Ausführungsform erfolgt ein Stummschalten des Hochfrequenz-Leistungsverstärkers 26 zu einem Zeitraum T1, der zwischen 0 und 10 Mikrosekunden nach dem Ende des Anregungspulses liegt. In einem Zeitraum von 5 bis 10 Mikrosekunden um T1 erfolgt dann ein Umschalten der Sende-Empfangsweiche 27 in den Empfangszustand, ein Verstimmen der Sende-Verstimmeinrichtung 15 und ein Abstimmen der Empfangs-Verstimmeinrichtung 51.

In einer möglichen Ausführungsform des Erfindungsgemäßen Verfahrens ist es auch denkbar, dass nach dem Ende des aktiven Anregungspulses die Steuerung 23 in einem Schritt S21 zunächst mit einem Sensor ein Abklingen der Schwingung in der Sendeantenne erfasst wird. Dabei ist es denkbar, dass die Schritte S22, S23 des Umschaltens vollständig oder teilweise während des Schritts S21 ausgeführt werden. Als Sensor kann beispielsweise die Lokalspule 50 genutzt werden, wenn im Sendezustand der Empfangs-Verstimmeinrichtung 51 das Eingangssignal so gedämpft wird, dass es quantitativ erfasst und ausgewertet werden kann. Denkbar ist es auch, dass in einem Sendezustand der Sende-Empfangsweiche 27 die Lokalspule 50 von dem Empfänger getrennt ist, aber ein Übersprechen der geöffneten Sende-Empfangsweiche 27 ausreicht, um den ausklingenden Anregungspuls quantitativ mit dem Empfänger zu erfassen. Schließlich kann der Magnetresonanztomograph 1 auch einen separaten Hochfrequenzsensor, beispielsweise eine Pickup-Spule für diesen Zweck aufweisen.

Sinkt dabei der Pegel des abklingenden Anregungspulses unter einen vorbestimmten Schwellwert, so schaltet die Steuerung 23 die Empfangs-Verstimmeinrichtung 51 und die Sende-Empfangsweiche 27 in einem Schritt S22 in den Empfangszustand und nimmt anschließend mit dem Schritt 30 den Empfang des Magnetresonanzsignals zu einem frühestmöglichen Zeitpunkt auf. Der vorbestimmte Schwellwert kann dabei aus dem exponentiellen Abfall des Magnetresonanzsignals und dem Störpegel so bestimmt werden, dass das zu erwartende SNR eine Bildgebung erlaubt.

Auf vorteilhafte Weise kann so auf unterschiedliche Dämpfungen durch den Patienten 100 eingegangen und das Signal optimiert werden. Der Schritt S21 kann dabei nur einmal am Beginn einer Messung für den Patienten 100 ausgeführt werden oder anschließend an jeden Anregungspuls.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Magnetresonanztomograph, wobei der Magnetresonanztomograph (1) eine Hochfrequenzeinheit (22), eine Sendeantenne und eine Empfangsantenne aufweist, wobei die Hochfrequenzeinheit (22) ausgelegt ist, die Sendeantenne und/oder Empfangsantenne in einer Zeit kleiner 40 Microsekunden von einem Sendezustand in einen Empfangszustand umzuschalten.

2. Magnetresonanztomograph nach Anspruch 1, wobei die Hochfrequenzeinheit (22) eine oder mehrere Verstimmeinrichtungen und/oder eine Sende-Empfangsweiche (27) und eine Ansteuerung aufweist, wobei die Ansteuerung die ausgelegt ist, für die Verstimmeinrichtung bzw. Verstimmeinrichtungen und/oder Sende-Empfangsweiche (27) gleichzeitig ein Umschalten von einem Sendezustand in einen Empfangszustand zu initiieren.

3. Magnetresonanztomograph nach Anspruch 2, wobei die Ansteuerung eine Synchronisierungseinrichtung aufweist, die ausgelegt ist, einen Jitter beim gleichzeitigen Umschalten auf einen Wert kleiner 5 Mikrosekunden, 2 Mikrosekunden oder 1 Mikrosekunde zu begrenzen.

4. Magnetresonanztomograph nach einem der vorhergehenden Ansprüche, wobei der Magnetresonanztomograph (1) eine Pickup-Spule zum Aufnehmen des Abklingens der Sendeantenne nach einem Aussenden eines Anregungspulses aufweist.

5. Magnetresonanztomograph nach einem der Ansprüche 1 bis 3, wobei die Hochfrequenzeinheit (22) ausgelegt ist, in dem Sendezustand mit der Empfangsantenne eine Aussendung der der Sendeantenne aufzunehmen.

6. Magnetresonanztomograph nach einem der vorhergehenden Ansprüche mit einer Sende-Empfangsweiche (27), wobei die Sende-Empfangsweiche (27) zwei Schalter zum Umschalten zwischen einem Sendezustand und einem Empfangszustand mit zwei unterschiedlichen Treiberkreisen aufweist, wobei der erste der Treiberkreisen eine längere Zeitkonstante als der zweite Treiberkreis aufweist.

7. Magnetresonanztomograph nach einem der vorhergehenden Ansprüche, wobei die Hochfrequenzeinheit (22) einen Hochfrequenz-Leistungsverstärker (26) mit einem Steuersignaleingang zum Unterdrücken einer Aussendung aufweist.

8. Verfahren zum Betrieb eines Magnetresonanztomographen (1) mit einer Hochfrequenzeinheit (22), wobei das Verfahren die Schritte aufweist:
- (S10) Anregen von Kernspins in einem Untersuchungsobjekt mit einem Anregungspuls durch die Hochfrequenzeinheit (22) über eine Sendeantenne in einem Sendezustand,
- (S20) Umschalten von dem Sendezustand in einen Empfangszustand;
- (S30) Empfangen eines Magnetresonanzsignals in dem Empfangszustand mit einer Empfangsantenne,
**dadurch gekennzeichnet, dass**
das Umschalten (S20) in weniger als 40 Microsekunden erfolgt.

9. Verfahren nach Anspruch 8, wobei die Hochfrequenzeinheit (22) beim Umschalten (S20) von einem Sendezustand in einen Empfangszustand in einem Schritt (S21) ein von der Sendeantenne ausgesendetes elektromagnetisches Wechselfeld erfasst und erst in einem Schritt (S22) in den Empfangszustand schaltet, wenn eine Stärke des elektromagnetischen Wechselfeldes einen vorbestimmten Grenzwert unterschreitet.

10. Verfahren nach einem der Ansprüche 8 oder 9, wobei die Hochfrequenzeinheit (22) eine Sende-Empfangsweiche (27) zwischen einem Hochfrequenz-Leistungsverstärker (26) und der Sendeantenne aufweist und die Sendeantenne im Empfangszustand in elektrischer Signalverbindung mit der Sendeantenne verbleibt.

11. Verfahren nach einem der Ansprüche 8 oder 9, wobei die Hochfrequenzeinheit (22) eine Sende-Empfangsweiche (27) zwischen einem Hochfrequenz-Leistungsverstärker (26) und der Sendeantenne mit zwei Schaltern zum Umschalten zwischen Sendezustand und Empfangszustand aufweist, wobei die Hochfrequenzeinheit (22) beim Umschalten von dem Sendezustand in den Empfangszustand die beiden Schalter in einem Schritt (S23) und (S34) nacheinander schaltet.

12. Verfahren nach einem der vorhergehenden Ansprüche 8 bis 11, wobei die Sendespule eine Körperspule (14) ist und die Körperspule (14) im Empfangszustand im abgestimmten Zustand verbleibt.

13. Computerprogrammprodukt, welches direkt in einen Prozessor einer programmierbaren Steuereinheit (20) eines Magnetresonanztomographen (1) nach einem der Ansprüche 1 bis 7 ladbar ist, mit Programmcode-Mitteln, um alle Schritte eines Verfahrens nach einem der Ansprüche 8 bis 12 auszuführen, wenn das Programmprodukt auf der Steuereinheit (20) ausgeführt wird.

14. Computerlesbares Speichermedium mit darauf gespeicherten elektronisch lesbaren Steuerinformationen, welche derart ausgestaltet sind, dass sie bei Verwendung des Speichermediums in einer Steuereinheit (20) eines Magnetresonanztomographen (1) nach einem der Ansprüche 1 bis 7 das Verfahren nach einem der Ansprüche 8 bis 12 durchführen.
